(19) **Europäisches Patentamt**
**European Patent Office**
**Office européen des brevets**

(11) **EP 4 730 648 A1**

(12) **EUROPEAN PATENT APPLICATION**

(43) Date of publication:
**22.04.2026 Bulletin 2026/17**

(21) Application number: **24207585.1**

(22) Date of filing: **18.10.2024**

(51) International Patent Classification (IPC):
**H03D 1/18** *(2006.01)*

(52) Cooperative Patent Classification (CPC):
**H03D 1/18**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(71) Applicants:
• **NXP USA, Inc.**
  **Austin, TX 78735 (US)**
• **L'Università degli Studi di Catania (DIEEI)**
  **95131 Catania (IT)**

(72) Inventors:
• **SCUDERI, Angelo**
  **5656AG Eindhoven (NL)**
• **COPANI, Tino**
  **5656AG Eindhoven (NL)**
• **GIUSTOLISI, Gianluca**
  **5656AG Eindhoven (NL)**
• **EGHTESADI, Minoo**
  **5656AG Eindhoven (NL)**
• **PENNISI, Salvatore**
  **5656AG Eindhoven (NL)**
• **RAGONESE, Egidio**
  **5656AG Eindhoven (NL)**

(74) Representative: **Hardingham, Christopher Mark**
**NXP Semiconductors**
**Intellectual Property Group**
**The Cattle Barn**
**Upper Ashfield Farm, Hoe Lane**
**Romsey, Hampshire SO51 9NJ (GB)**

(54) **FULLY DIFFERENTIAL CMOS DEMODULATOR**

(57)    A fully differential CMOS demodulator includes a CMOS bias control circuit, a CMOS squarer rectifier, a CMOS summing circuit, at least one CMOS gain stage, and a CMOS mismatch control circuit. CMOS bias control circuit produces a bias signal that biases the other components. The CMOS squarer rectifier receives the reference voltage, a first modulated analog information signal, and a second modulated analog information signal and demodulates the first and second modulated analog information signals to produce differential demodulated information signals and average voltage levels of the differential demodulated information signals. The CMOS summing circuit sums the differential demodulated information signals and average voltage levels of the differential demodulated information signals to produce a differential demodulated information signal pair. The at least one CMOS gain stage amplifies the differential demodulated information signal pair, and the CMOS mismatch control circuit alters the differential demodulated information signal pair for offset compensation.

**FIG. 2**

**Description**

**BACKGROUND OF THE INVENTION**

FIELD OF THE INVENTION

The disclosed subject matter relates to demodulators formed within integrated circuits, and more particularly to demodulators formed in CMOS integrated circuits.

**DESCRIPTION OF RELATED ART**

Communication systems are known to support wireless and wire lined communications between wireless and/or wire lined communication devices. Such communication systems range from national and/or international cellular telephone systems to the Internet to point-to-point wireless networks. Each type of communication system operates in accordance with one or more communication standards.

A wireless communication device, such as a cellular telephone, two-way radio, personal digital assistant (PDA), personal computer (PC), laptop computer, home entertainment equipment, RFID reader, RFID tag, wireless sensor, wireless Internet of Things device, etc., communicates with one or more other wireless communication devices. Each wireless communication device includes a built-in radio transceiver (i.e., receiver and transmitter). As is known, the receiver is coupled to an antenna and includes a Low Noise Amplifier (LNA), may include one or more intermediate frequency (IF) stages, a filtering stage, and a data recovery stage. The LNA receives inbound RF signals via the antenna and amplifies the signals. If present, the one or more intermediate frequency stages mix the amplified RF signals with one or more local oscillations to convert the amplified RF signal into baseband signals or intermediate frequency (IF) signals. The filtering stage filters the RF, IF, and/or baseband signals to attenuate unwanted out of band signals to produce filtered signals. The data recovery stage recovers raw data from the filtered signals in accordance with one or more wireless communication standards.

As is also known, the transmitter includes a data modulation stage, one or more intermediate frequency stages, and a power amplifier. The data modulation stage converts raw data into baseband signals in accordance with a particular wireless communication standard. The one or more intermediate frequency stages mix the baseband signals with one or more local oscillations to produce RF signals. The power amplifier amplifies the RF signals prior to transmission via an antenna.

With low cost and/or low power devices servicing high data rate communications, e.g., battery powered devices, simpler modulation formats are used, which may include Amplitude Shift Keying (ASK) and On Off Keying (OOK), which may service data rates more than 1 GBIT/S. Prior ASK/OOK demodulators were implemented either in bipolar/BiCMOS or in CMOS technologies. Many of the prior demodulators were based on single-ended or pseudo-differential circuits along with RC low-pass or LC notch filtering. Although a bipolar transistor is more suited for demodulation due to its high non-linear behaviour compared to modem nanoscale Complementary Metal Oxide Semiconductor (CMOS) devices, CMOS demodulators are more attractive since most RF/mm-wave applications have moved to pure CMOS devices/processes to reduce costs and increase the level of integration (i.e., system on chip).

At RF/mm-wave frequencies, single-ended or pseudo differential structures suffer from ground and power supply (high-frequency) noise. With the prior solutions, a single-ended demodulated signal was produced, which required using an additional block for single-ended-to-differential conversion to couple with the subsequent (differential) amplification stages. Such conversion could couple ground noise to an information signal. Thus, a need exists for an improved demodulator.

**BRIEF DESCRIPTION OF THE DRAWINGS**

One or more embodiments are described by way of example with reference to the accompanying drawings, in which:

FIG. 1 is a block diagram illustrating components of a wireless receiver having a fully differential CMOS demodulator constructed and operating according to one or more embodiments of the present disclosure;

FIG. 2 is a block diagram illustrating components of a fully differential CMOS demodulator constructed and operating according to one or more embodiments of the present disclosure;

FIG. 3 is a circuit diagram illustrating components of a fully differential CMOS demodulator constructed and operating according to one or more embodiments of the present disclosure;

FIG. 4 is a circuit diagram illustrating components of a CMOS squarer rectifier of the fully differential CMOS demodulator constructed and operating according to one or more embodiments of the present disclosure;

FIG. 5A is a diagram illustrating differential components of an On Off Keying (OOK) modulated information signal upon which a CMOS squarer rectifier of the fully differential CMOS demodulator operates according to one or more embodiments of the present disclosure;

FIG. 5B is a diagram illustrating differential squared components of the OOK modulated information signal produced by the CMOS squarer rectifier of the fully differential CMOS demodulator according to one or more embodiments of the present disclosure;

FIG. 6 is a graph illustrating operational characteristics of the CMOS squarer rectifier of the fully differential CMOS demodulator according to one or more embodiments of the present disclosure;

FIG. 7 is a block and signal diagram illustrating components of a CMOS summing circuit of the fully differential CMOS demodulator and illustrating signals upon which it receives and produces constructed and operating according to one or more embodiments of the present disclosure;

FIG. 8 is a circuit diagram illustrating components of a CMOS summing circuit of the fully differential CMOS demodulator according to one or more embodiments of the present disclosure;

FIG. 9A is a circuit diagram illustrating a CMOS gain stage of the fully differential CMOS demodulator according to one or more embodiments of the present disclosure;

FIG. 9B is a block diagram illustrating a plurality of CMOS gain stages of the fully differential CMOS demodulator according to one or more embodiments of the present disclosure;

FIG. 10 is a circuit diagram illustrating components of a CMOS bias control circuit of the fully differential CMOS demodulator according to one or more embodiments of the present disclosure;

FIG. 11 is a circuit diagram illustrating components of a CMOS mismatch control circuit of the fully differential CMOS demodulator according to one or more embodiments of the present disclosure;

FIG. 12 is a diagram illustrating circuit components and interconnectivity of a CMOS summing circuit, CMOS gain stage(s), and a CMOS mismatch control circuit of the fully differential CMOS demodulator according to one or more embodiments of the present disclosure; and

FIG. 13 is a flow diagram illustrating operations of a fully differential CMOS demodulator according to one or more embodiments of the present disclosure.

## DETAILED DESCRIPTION

One or more embodiments are described by way of example with reference to the accompanying drawings, in which:

A fully differential CMOS demodulator includes a CMOS bias control circuit, a CMOS squarer rectifier, a CMOS summing circuit, at least one CMOS gain stage, and a CMOS mismatch control circuit. The fully differential CMOS demodulator provides a low cost and low power consumption solution since it is formed in a CMOS process. Because the CMOS demodulator of the present disclosure is fully differential it reduces noise coupling from a ground plane and/or other components of an Integrated Circuit in which it may be formed. Further, the fully differential CMOS demodulator of the present disclosure includes the CMOS biasing circuit and the CMOS mismatch control circuit that provide operational advantages to produce matched and accurate differential signals as output.

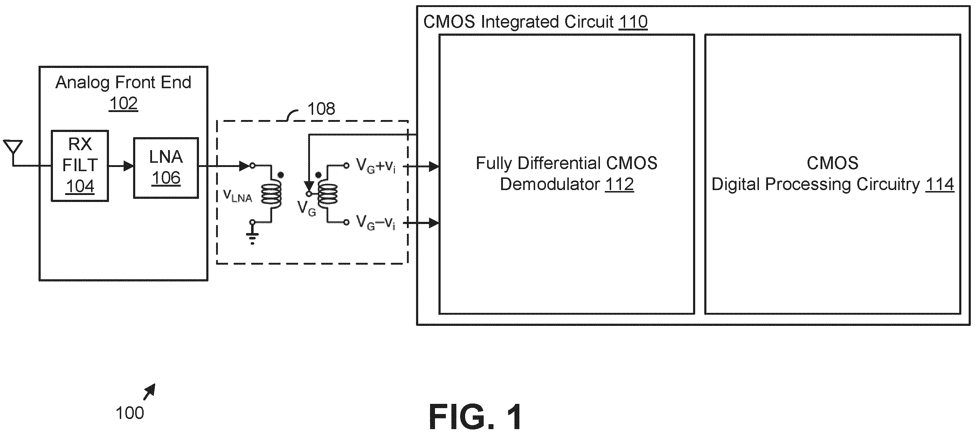

FIG. 1 is a block diagram illustrating components of a wireless receiver having a fully differential Complementary Metal Oxide Semiconductor (CMOS) demodulator constructed and operating according to one or more embodiments of the present disclosure. The wireless receiver 100 includes an analog front end 102 having receive filtering 104 that receives a wireless modulated information signal via an antenna and filters the modulated information signal. A Low Noise Amplifier (LNA) 106 receives the modulated information signal and amplifies the modulated information signal to produce a filtered single ended analog information signal $v_i$. An LNA transformer 108 includes a first coil receiving the filtered singled ended analog information signal from the LNA 106 and a second coil magnetically coupled to the first coil, the second coil having a center tap receiving a voltage reference $V_G$, a positive terminal producing $V_G+v_i$ and negative terminal producing $V_G-v_i$. In another embodiment, the LNA 106 may be differential with the output of the LNA 106 being differential.

A CMOS integrated circuit 110 couples to the LNA transformer 108 and includes a fully differential CMOS demodulator 112 that receives $V_G$, $V_G+v_i$, and $V_G-v_i$. The fully differential CMOS demodulator 112 processes $V_G$, $V_G+v_i$, and $V_G-v_i$ to produce a differential demodulated information signal pair $v_{sp}$ and $v_{sn}$, which is a bit stream in some embodiments at data rates that may exceed 1 Gigabit/second. CMOS digital processing circuitry 114 receives and processes the differential demodulated information signal pair $v_{sp}$ and $v_{sn}$ to produce received data. The received data may be any type of digital data used by the wireless receiver 100.

The wireless receiver 100 may form part of a wireless device, which may be battery powered. The CMOS integrated circuit 110 provides a power efficient solution. With the fully differential CMOS demodulator 112 being part of the CMOS integrated circuit 110, the wireless device consumes less power than a wireless device having a receiver formed in a bipolar or bipolar/CMOS process. Further, the fully differential CMOS demodulator 112 is more resistance to noise coupling from a ground plane or other sources of noise in the CMOS integrated circuit 110. Thus, the fully differential CMOS demodulator 112 of the present invention provides both power consumption and noise resistance performance as compared to prior solutions.

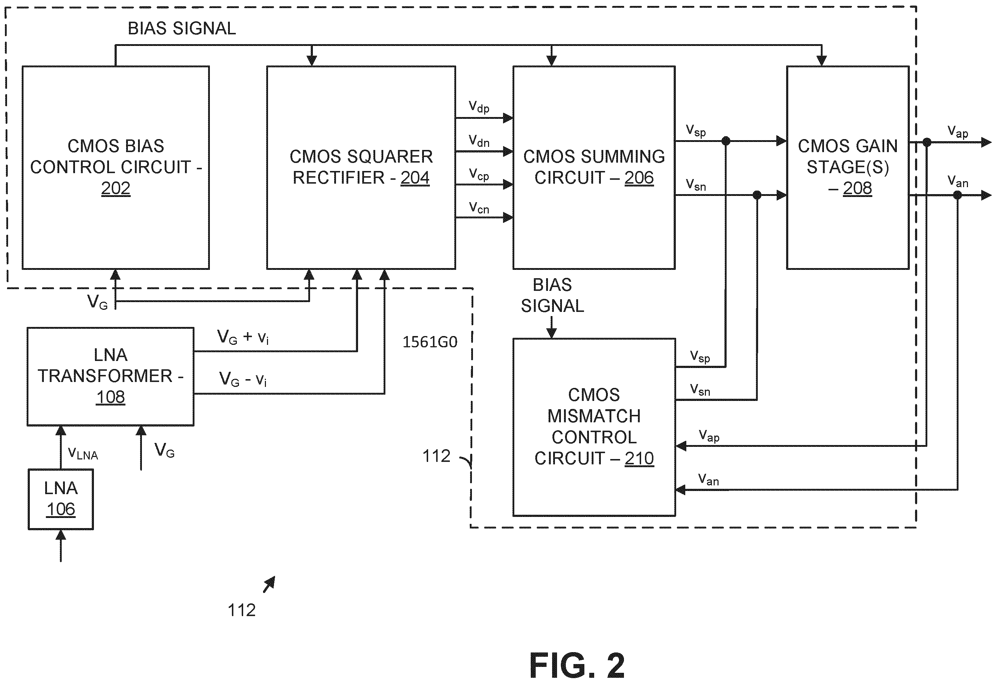

FIG. 2 is a block diagram illustrating components of a fully differential CMOS demodulator constructed and operating according to one or more embodiments of the present disclosure. Further shown in FIG. 2 are the LNA 106 and the LNA transformer 108. The fully differential CMOS demodulator 112 includes a CMOS bias control circuit 202, a CMOS squarer rectifier 204, a CMOS summing circuit 206, one or more CMOS gain stage(s) 208 and a CMOS mismatch control circuit 210 intercoupled as illustrated.

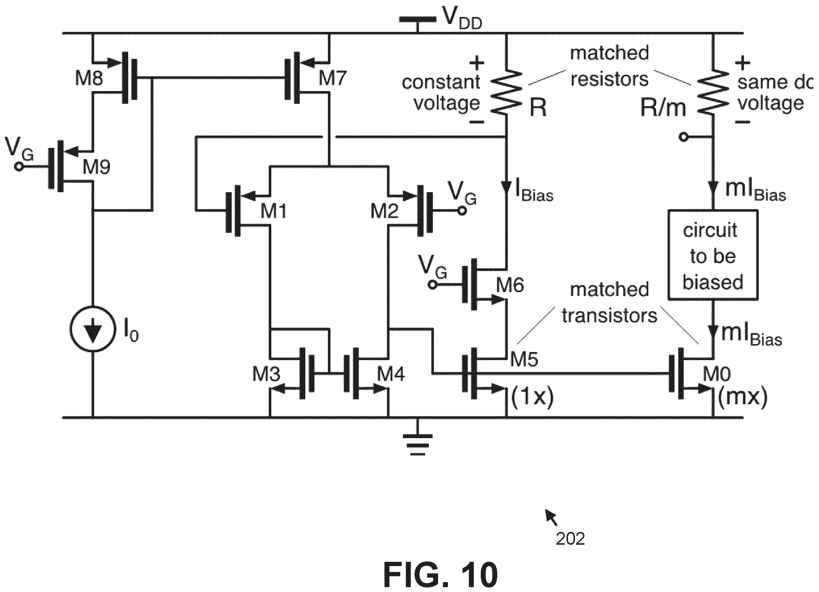

The CMOS bias control circuit 202 has a plurality of CMOS transistors and at least one resistor. The CMOS bias control circuit 202 receives a reference voltage $V_G$ and produces a bias signal based upon the reference voltage $V_G$. An embodiment of the CMOS bias control circuit 202 will be described herein with reference to FIG. 10.

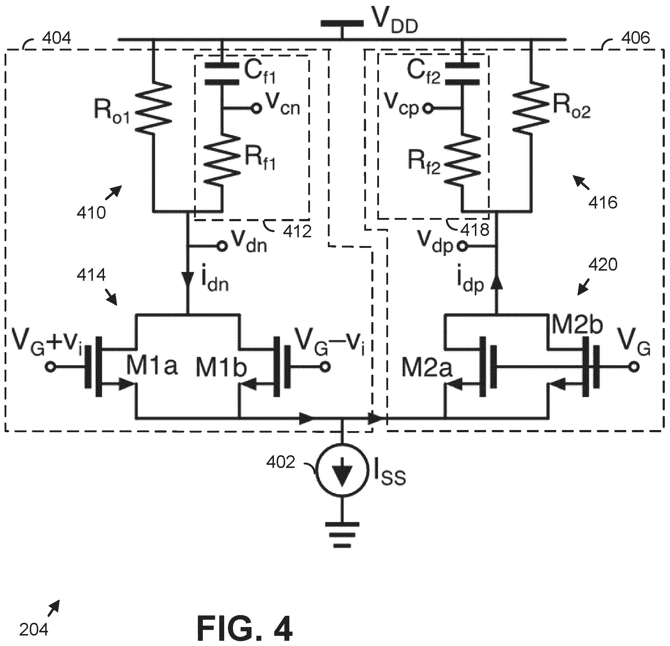

The CMOS squarer rectifier 204 includes a plurality of CMOS transistors and a plurality of resistors. The CMOS squarer rectifier 204 is biased by the bias signal. The CMOS squarer rectifier 204 receives the reference voltage $V_G$ and input signals including a first modulated analog information signal $V_G+v_i$, and a second modulated analog information signal $V_G-v_i$, wherein $v_i$ is a single ended modulated analog information signal. The CMOS squarer rectifier 204 demodulates the first and second modulated analog information signals $V_G+v_i$ and $V_G-v_i$ to produce a set of demodulated information signals including a positive demodulated information signal $v_{dp}$, a negative demodulated information signal $v_{dn}$, an average voltage level $v_{cp}$ of the positive demodulated information signal $v_{dp}$, and an average voltage level $v_{cn}$ of the negative demodulated information signal $v_{dn}$. Embodiment of the CMOS squarer rectifier 204 and its operation will be described herein with reference to FIGs. 4, 5A, 5B, and 6.

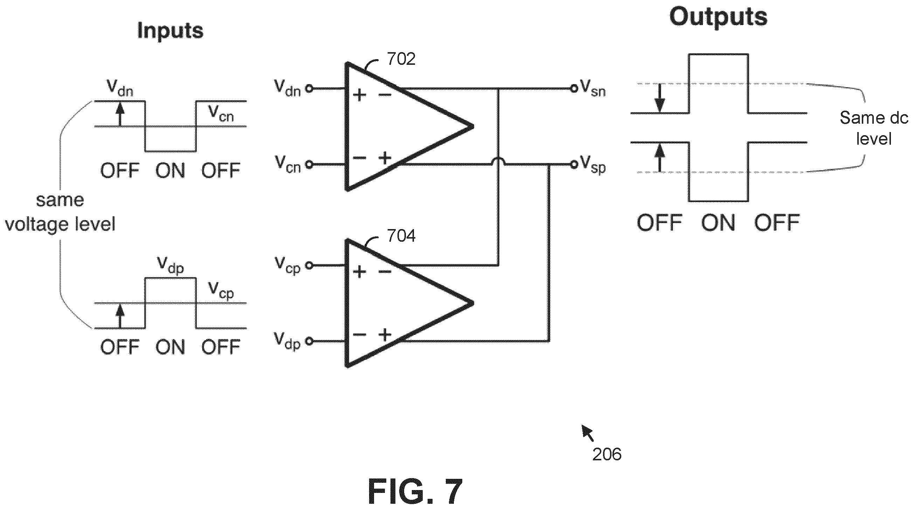

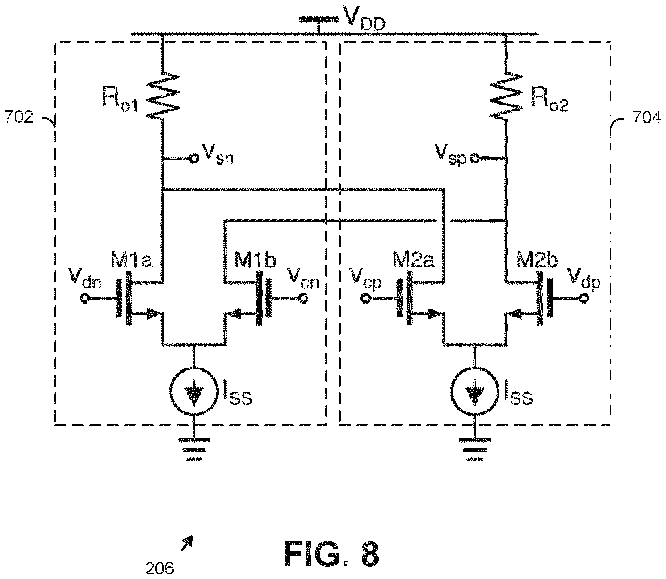

The CMOS summing circuit 206 has a plurality of CMOS transistors and a plurality of resistors. The CMOS summing circuit 206 is biased by the bias signal. The CMOS summing circuit receives $v_{dp}$, $v_{dn}$, $v_{cp}$, and $v_{cn}$ (the set of demodulated information signals in some embodiments) and sums $v_{dp}$, $v_{dn}$, $v_{cp}$, and $v_{cn}$ to produce a differential demodulated information signal pair $v_{sp}$ and $v_{sn}$. Embodiments of the CMOS summing circuit 206 and its operation will be described herein with reference to FIGs. 7 and 8.

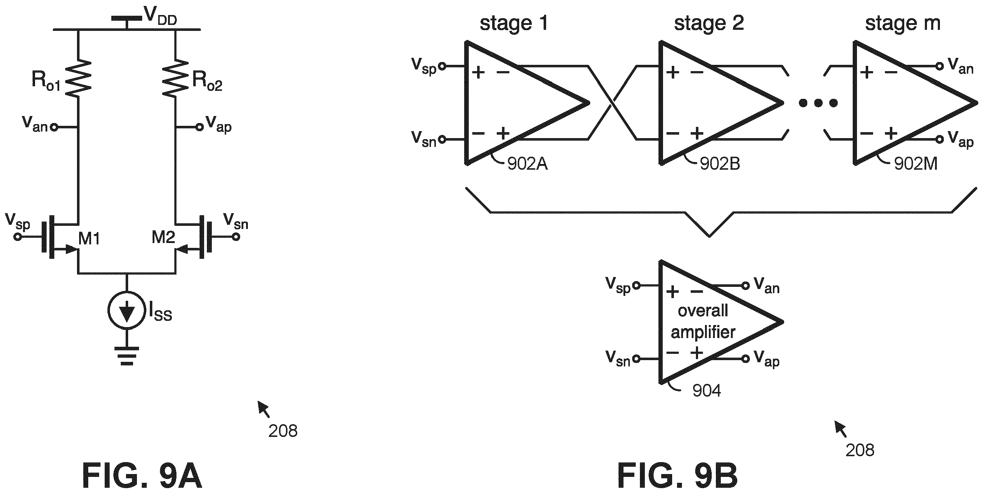

The at least one CMOS gain stage(s) 208 is biased by the bias signal, receives the differential demodulated information signal pair $v_{sp}$ and $v_{sn}$, and amplifies the differential demodulated information signal pair $v_{sp}$ and $v_{sn}$ to produce an amplified differential information signal pair $v_{ap}$ and $v_{an}$. Embodiments of the CMOS gain stage(s) 208 and its operation will be described herein with reference to FIGs. 9A and 9B.

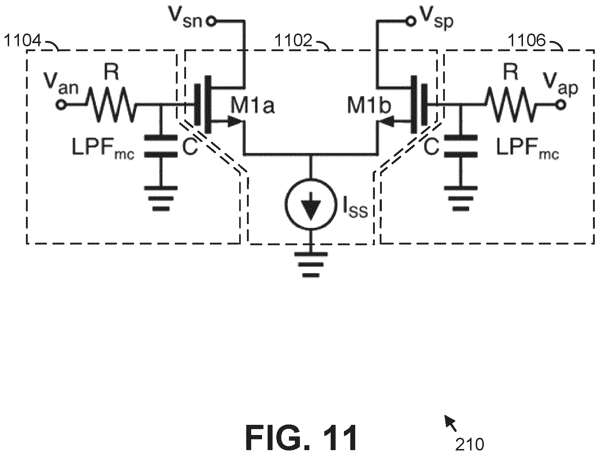

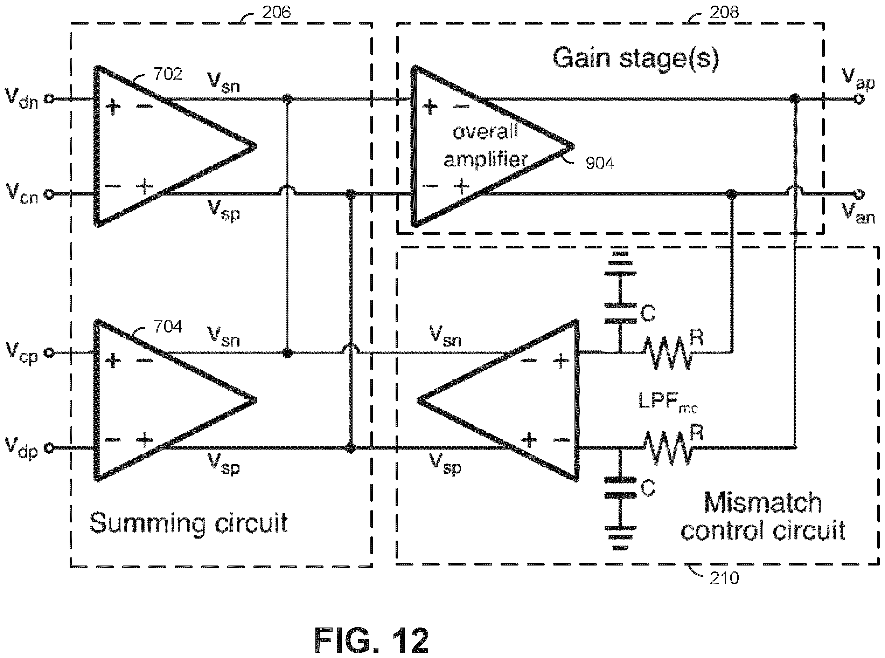

The CMOS mismatch control circuit 210 has a plurality of CMOS transistors and a plurality of resistors. The CMOS mismatch control circuit 202 is biased by the bias signal, receives the amplified differential information signal pair $v_{ap}$ and $v_{an}$, and alters the differential demodulated information signal pair $v_{sp}$ and $v_{sn}$ for offset compensation. Embodiments of the CMOS mismatch control circuit 210 and its interconnection with the CMOS summing circuit 206 and the at least one CMOS gain stage(s) 208 will be described herein with reference to FIGs. 11 and 12.

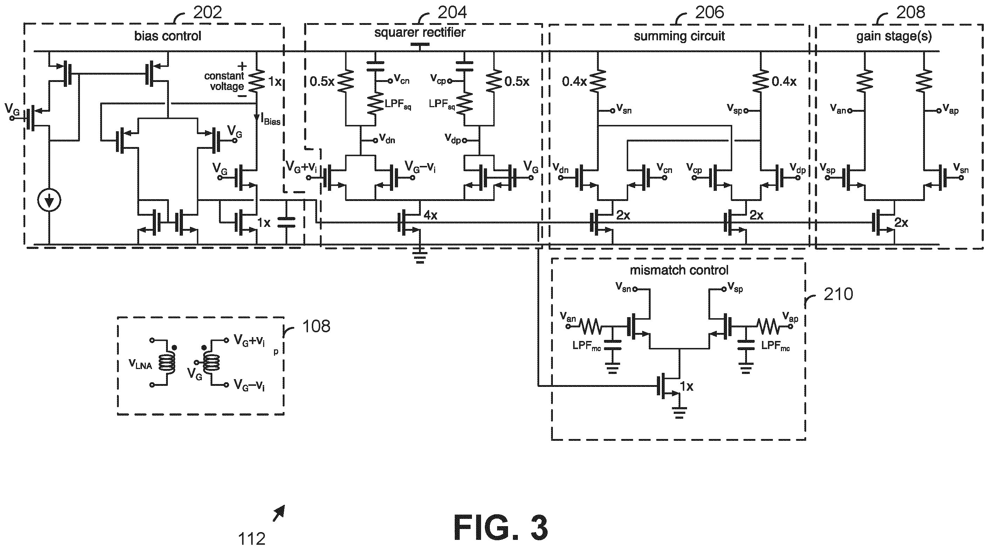

FIG. 3 is a circuit diagram illustrating components of a fully differential CMOS demodulator constructed and operating according to one or more embodiments of the present disclosure. The embodiment of FIG. 3 illustrates CMOS circuitry that may be employed and the interconnections of the fully differential CMOS demodulator 112. Further shown in FIG. 3 is the LNA transformer 108. As shown, the fully differential CMOS demodulator 112 includes a CMOS bias control circuit 202, a CMOS squarer rectifier 204, a CMOS summing circuit 206, one or more CMOS gain stage(s) 208 and a CMOS mismatch control circuit 210 are intercoupled as illustrated. The signals identified in FIG. 3 are consistent with the signals identified in FIG. 2.

An embodiment of the CMOS bias control circuit 202 will be described herein with reference to FIG. 10. Embodiment of the CMOS squarer rectifier 204 and its operation will be described herein with reference to FIGs. 4, 5A, 5B, and 6. Embodiments of the CMOS summing circuit 206 and its operation will be described herein with reference to FIGs. 7 and 8. Embodiments of the CMOS gain stage(s) 208 and its operation will be described herein with reference to FIGs. 9A and 9B. Embodiments of the CMOS mismatch control circuit 210 and its interconnection with the CMOS summing circuit 206 and the at least one CMOS gain stage(s) 208 will be described herein with reference to FIGs. 11 and 12.

The CMOS mismatch control circuit 210 has a plurality of CMOS transistors and a plurality of resistors. The CMOS mismatch control circuit 202 is biased by the bias signal, receives the amplified differential information signal pair $v_{ap}$ and $v_{an}$, and alters the differential demodulated information signal pair $v_{sp}$ and $v_{sn}$ for offset compensation. Embodiments of the CMOS mismatch control circuit 210 and its interconnection with the CMOS summing circuit 206 and the at least one CMOS gain stage(s) 208 will be described herein with reference to FIGs. 11 and 12.

FIG. 4 is a circuit diagram illustrating components of a CMOS squarer rectifier of the fully differential CMOS demodulator constructed and operating according to one or more embodiments of the present disclosure. The CMOS squarer rectifier 204 includes a current source 402 controlled by the bias signal and having a current source 402 input and a current source 402 output coupled to ground. The CMOS rectifier 204 also includes a first leg 404 and a second leg 406, each coupled between a source voltage $V_{DD}$ and the current source 402 input.

The first leg 404 includes a first circuit 410 having a first load resistor $R_{ol}$ coupled in parallel with a first low pass filter 412, the first circuit 410 couples between a source voltage $V_{DD}$ and a first output node producing $v_{dn}$. The first low pass filter 412 includes capacitor $C_{f1}$ and resistor $R_{f1}$ and produces $v_{cn}$. The first leg 404 also includes a first CMOS transistor pair 414 having a first CMOS transistor M1a and a second CMOS transistor M1b. The first CMOS transistor M1a has a drain coupled to the first output node, a source coupled to the current source 402 input, and a gate receiving $V_G + v_i$. The second CMOS transistor M1b couples in parallel with the first CMOS transistor M1a, has a drain coupled to the first output node, a source coupled to the current source 402 input, and a gate receiving $V_G - v_i$.

The second leg 406 has a second circuit 416 that includes a second load resistor $R_{o2}$ coupled in parallel with a second low pass filter 418. The second low pass filter 418 includes capacitor $C_{f2}$ and resistor $R_{f2}$ and produces $v_{cp}$. The second circuit 416 couples between the source voltage $V_{DD}$ and a second output node producing $v_{dp}$ with the second low pass filter producing $v_{cp}$. The second leg also includes a second CMOS transistor pair 420 having a third CMOS transistor M2a and a fourth CMOS transistor M2b. The third CMOS transistor M2a has a drain coupled to the second output node, a source coupled to the current source 402 input, and a gate receiving $V_G$. The fourth CMOS transistor M2b couples in parallel with the third CMOS transistor M2a, has a drain coupled to the second output node, a source coupled to the current source 402 input, and a gate receiving $V_G$.

The CMOS squarer rectifier 204 exploits the non-linearity of the CMOS transistors, which may be modelled as:

$$i_D(V_{GS} \pm v_i) \approx I_D(V_{GS}) \pm g_m v_i + \frac{k_2}{2} v_i^2 \quad \text{where} \quad k_2 = \frac{\partial^2 i_D}{\partial v_{GS}^2} \qquad \text{equation (1)}$$

The small-signal currents generated by transistors M1a and M1b and M2a and M2b results in:

$$i_{dn} = i_{dp} = k_2 v_i^2 \qquad \text{equation (2)}$$

If the modulated information signal is $v_i = V_I \sin(\omega t)$, the amplitude of the demodulated signals, $v_{dp,n}$, is:

$$V_{OM} = \left(\frac{1}{4}\frac{k_2}{I_D}\alpha\Delta V\right)V_I^2 \qquad \text{equation (3)}$$

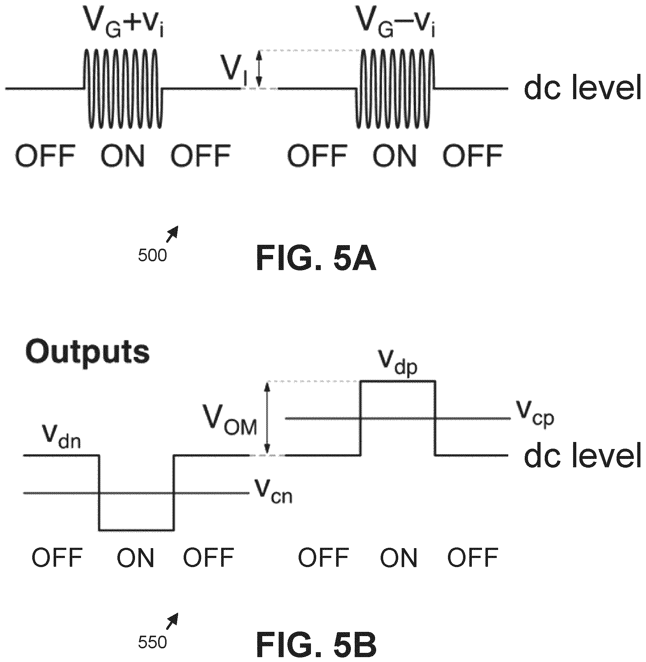

where $\Delta V = I_{SS}R_o/2$ is the dc voltage drop across the load resistors $R_{o1}$ and $R_{o2}$. In such case, $\alpha = R_f/(R_o + R_f)$ is a partition loss, and $k_2/I_D$ is the nonlinearity characteristic of the CMOS device. The low pass filters 412 and 416, $R_fC_f$, produce the average values $v_{cn}$ and $v_{cp}$ of the demodulated differential signals $v_{dn}$ and $v_{dp}$, respectively, for the subsequent CMOS summing circuit 206. $V_{OM}$ is further illustrated in FIG. 5B.

FIG. 5A is a diagram illustrating differential components of an On Off Keying (OOK) modulated information signal upon which a CMOS squarer rectifier of the fully differential CMOS demodulator operates according to one or more embodiments of the present disclosure. FIG. 5B is a diagram illustrating differential squared components of the OOK modulated information signal produced by the CMOS squarer rectifier 204 of the fully differential CMOS demodulator according to one or more embodiments of the present disclosure.

Referring to FIG. 5A, with OOK, the information signal 500 is modulated with a sinusoid having magnitude Vi to represent one data state, e.g., logic one. Further, with OOK, the information signal is not modulated with the sinusoid to represent another state, e.g., logic zero, such that OOK signal is at a dc level. With OOK there is no carrier during the transmission of logic zero. The carrier is transmitted only during the transmission of a logic one. In OOK a transmitter goes to IDLE state during transmission of logic "zero". With Amplitude Shift Keying (ASK), logic zero is represented by a lower amplitude of a sinusoid and logic one is represented by a higher amplitude of the sinusoid. Thus, OOK helps with conserving battery power in battery powered wireless devices as compared to ASK. The CMOS fully differential demodulator 112 works for demodulating both OOK and ASK signals, although minor variations may be required for the differing demodulations.

Signals $V_G$, $V_G + v_i$, $V_G - v_i$ are output by the LNA transformer 108 and received by the CMOS squarer rectifier 204. The CMOS squarer rectifier 204 demodulates the first and second modulated analog information signals $V_G + v_i$ and $V_G - v_i$ to produce a positive demodulated information signal $v_{dp}$, a negative demodulated information signal $v_{dn}$, an average voltage level $v_{cp}$ of the positive demodulated information signal $v_{dp}$, and an average voltage level $v_{cn}$ of the negative demodulated information signal $v_{dn}$ 550 as shown in FIG. 5B. Note that the magnitude of each of $v_{dn}$ and $v_{cp}$ when in the ON state with respect to the DC level is $V_{OM}$.

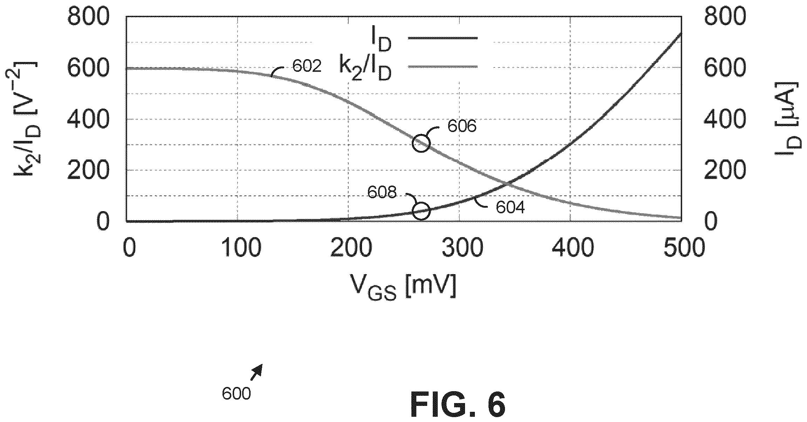

FIG. 6 is a graph illustrating operational characteristics of the CMOS squarer rectifier of the fully differential CMOS demodulator according to one or more embodiments of the present disclosure. The graph 600 includes $V_{GS}$ [mV] on the horizontal axis, $k_2/I_D$ [V$^{-2}$] on a left vertical axis and $I_D$ [μA] on a right vertical axis. $k_2/I_D$ curve 602 and $I_D$ 604 are graphed. An optimum biasing point for the CMOS squarer rectifier is obtained by maximizing the slope of $k_2/I_D$ for a substantially optimal tradeoff between power and speed of operation with such optimum biasing point illustrated at points 606 and 608 of curves 602 and 604, respectively.

FIG. 7 is a block and signal diagram illustrating components of a CMOS summing circuit of the fully differential CMOS demodulator and illustrating signals upon which it receives and produces constructed and operating according to one or more embodiments of the present disclosure. The summing circuit 206 includes a first differential amplifier 702 and a second differential amplifier 704 cross coupled with the first differential amplifier 702. The first differential amplifier 702 receives $v_{dn}$ and $v_{cn}$ and produces $v_{sn}$ and $v_{sp}$. The second differential amplifier 704 receives $v_{dp}$ and $v_{cp}$ and produces $v_{sn}$ and $v_{sp}$ in conjunction with the first differential amplifier 702 via output coupling with the first differential amplifier 702.

FIG. 8 is a circuit diagram illustrating components of the CMOS summing circuit of the fully differential CMOS demodulator of FIG. 7 according to one or more embodiments of the present disclosure. The CMOS summing circuit 206 includes the first differential amplifier 702 and the second differential amplifier 704 cross coupled with the first differential amplifier 702. The first differential amplifier 702 receives $v_{dn}$ and $v_{cn}$ and produces $v_{sn}$ and $v_{sp}$; and the second differential amplifier 704 receives $v_{dp}$ and $v_{cp}$ and produces $v_{sn}$ and $v_{sp}$ in conjunction with the first differential amplifier 702 via output coupling with the first differential amplifier 702.

The first differential amplifier 702 includes resistor $R_{01}$, transistor M1a, transistor M1b, and current source Iss. The second differential amplifier 704 includes resistor $R_{02}$, transistor M2a, transistor M2b, and current source Iss. These components are coupled between $V_{DD}$ and ground and cross-coupled with each other as illustrated. The summing circuit is made up of two crossed differential amplifiers.

The first differential amplifier 702 transistor pair M1a and M1b compares the negative output of the squarer rectifier $v_{dn}$ with its average value $v_{cn}$. The second differential amplifier 704 transistor pair M2a and M2b compares the positive output of the squarer rectifier $v_{dp}$ with its average value $v_{cp}$. The four drain currents of transistors M1a, M1b, M2a, and M2b are summed to produce the pure differential digital signals $v_{sn}$ and $v_{sp}$.

FIG. 9A is a circuit diagram illustrating a CMOS gain stage of the fully differential CMOS demodulator according to one or more embodiments of the present disclosure. The CMOS gain stage 208 includes a source-coupled differential transistor pair M1 and M2 with resistive loads Ro1 and Ro2, respectively. Gates of transistors M1 and M2 receive $v_{sp}$ and $v_{sn}$, respectively. Outputs $v_{an}$ and $v_{ap}$ are produced by the CMOS gain state 208 as illustrated.

FIG. 9B is a block diagram illustrating a plurality of CMOS gain stages of the fully differential CMOS demodulator according to one or more embodiments of the present disclosure. Gain stages 902A, 902B, ...., 902M are cascaded as illustrated such that the overall amplifier 904 provides sufficient gain. This cascade of M CMOS gain stages 208 is considered as an overall amplifier 904. The gain provided by the overall amplifier 904 is sufficient to increase produce $v_{an}$ and $v_{ap}$ at sufficient voltage to be operated on by the CMOS digital processing circuitry 114.

FIG. 10 is a circuit diagram illustrating components of a CMOS bias control circuit of the fully differential CMOS demodulator according to one or more embodiments of the present disclosure. With the embodiment of FIG. 10, the CMOS bias control circuit 202 is a two-stage operational transconductance amplifier (OTA) with a control resistor R. With the feedback of this design, the two-stage OTA sets the voltage drop across the resistor R to $V_{DD}$ - $V_G$, independently from process, voltage and temperature (PVT) variations. With the embodiment of FIG. 10, the current $I_{Bias} = (V_{DD} - V_G)/R$ is set to track variations of the control resistor R. The current $I_{Bias}$ is mirrored to transistor M0 with a multiplication factor, m, defined by the aspect ratio of transistor M0 with respect to that of transistor M5. When current $mI_{Bias}$ crosses a resistor R/m (matched with R) it produces the same voltage drop, independently of PVT variations. The bias signal $mI_{Bias}$ produced is provided to each circuit to be biased, as illustrated in FIG. 2, although it may be converted to a voltage signal prior to being provided to the circuit(s) to be biased.

FIG. 11 is a circuit diagram illustrating components of a CMOS mismatch control circuit of the fully differential CMOS demodulator according to one or more embodiments of the present disclosure. FIG. 12 is a diagram illustrating circuit components and interconnectivity of a CMOS summing circuit, CMOS gain stage(s), and a CMOS mismatch control circuit of the fully differential CMOS demodulator according to one or more embodiments of the present disclosure. Referring to FIG. 11, the CMOS mismatch control circuit 210 is made up of a source-coupled differential pair that works in conjunction to the CMOS summing circuit 208 and the CMOS Gain stage(s) 210. The CMOS mismatch control circuit 210 includes a differential amplifier 1102, a first low pass filter 1104, and a second low pass filter 1106 intercoupled with the CMOS summing circuit 206 and the at least one CMOS gain stage 208. The differential amplifier 1102 includes current source Iss, transistor M1a and transistor M1b coupled between $v_{sn}$ and $v_{sp}$ and ground as shown. Each of the first low pass filter 1104 and the second low pass filter 1106 includes a capacitor C and a resistor R.

Referring to both FIGs. 11 and 12, the low pass filters (LPF$_{mc}$) 1104 and 1106 detect the bias voltages at the outputs $v_{ap}$ and $v_{an}$ of the CMOS gain stage(s) 208. If these bias voltages $v_{ap}$ and $v_{an}$ are different, two compensation bias currents (with opposite signs) are fed back to the outputs $v_{ap}$ and $v_{an}$ of the CMOS summing circuit 206 (also the inputs of the CMOS gain stage(s) 208). The CMOS mismatch control circuit 210 compensates for the offset at the output of the CMOS gain stage(s) 208 caused by any mismatch effects (i.e., intra-die variations, temperature drift, aging, etc.), thus avoiding the need of periodic calibrations.

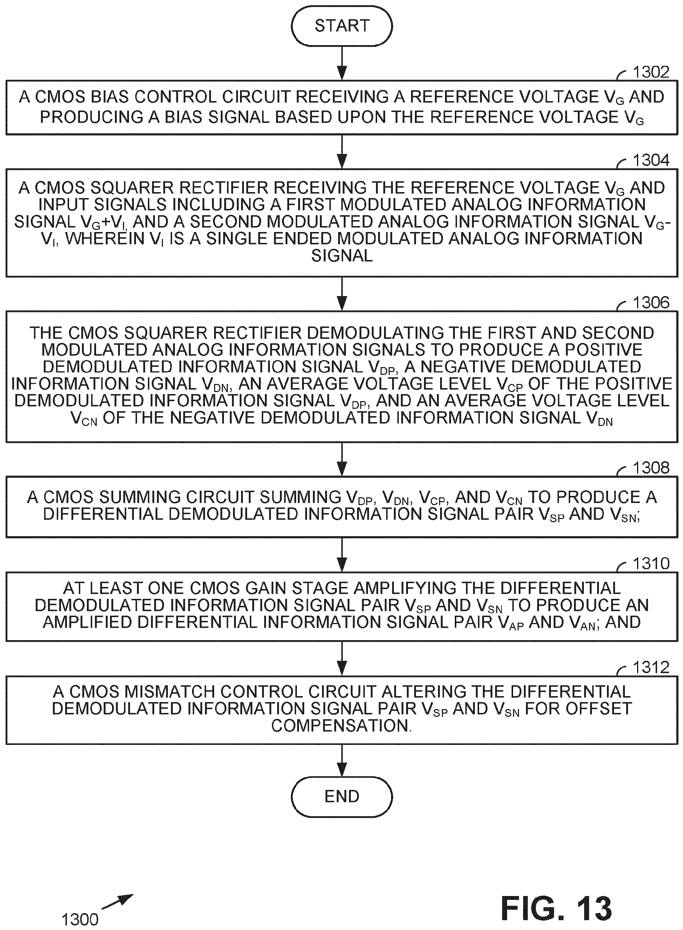

FIG. 13 is a flow diagram illustrating operations of a fully differential CMOS demodulator according to one or more embodiments of the present disclosure. The operations 1300 of FIG. 13 may be performed by the fully differential CMOS demodulator 112 illustrated in FIGs. 1 and 2 and as subsequently described with reference to FIGs. 3 through 12. Alternately, the operations 1300 of FIG. 13 may be performed by a fully differential CMOS demodulator having a differing structure.

Operations 1300 begin with a CMOS bias control circuit receiving a reference voltage $V_G$ and producing a bias signal based upon the reference voltage $V_G$ (step 1302). Operations continue with a CMOS squarer rectifier, biased by the bias signal, receiving the reference voltage $V_G$ and input signals including a first modulated analog information signal $V_G+v_i$ and a second modulated analog information signal $V_G-v_i$, wherein $v_i$ is a single ended modulated analog information signal (step 1304). Operations 1300 continue with the CMOS squarer rectifier further demodulating the first and second modulated analog information signals to produce a set of demodulated information signals. The set of demodulated information signals may include a positive demodulated information signal $v_{dp}$, a negative demodulated information signal $v_{dn}$, an average voltage level $v_{cp}$ of the positive demodulated information signal $v_{dp}$, and an average voltage level $v_{cn}$ of the negative demodulated information signal $v_{dn}$ (step 1306).

Operations 1300 next include a CMOS summing circuit, biased by the bias signal, receiving the set of demodulated information signals ($v_{dp}$, $v_{dn}$, $v_{cp}$, and $v_{cn}$) and summing $v_{dp}$, $v_{dn}$, $v_{cp}$, and $v_{cn}$ to produce a differential demodulated information signal pair $v_{sp}$ and $v_{sn}$ (step 1308). Operations 1300 further include at least one CMOS gain stage, biased by the bias signal, receiving the differential demodulated information signal pair $v_{sp}$ and $v_{sn}$ and amplifying the differential demodulated information signal pair $v_{sp}$ and $v_{sn}$ to produce an amplified differential information signal pair $v_{ap}$ and $v_{an}$ (step 1310). Operations conclude with a CMOS mismatch control circuit, biased by the bias signal, receiving the amplified differential information signal pair $v_{ap}$ and $v_{an}$ and altering the differential demodulated information signal pair $v_{sp}$ and $v_{sn}$ for offset compensation. (step 1312).

As will be appreciated, the steps of FIG. 13 may be performed in differing orders or simultaneously as a fully differential CMOS demodulator operates. Further some of the steps of FIG. 13 may not be present in some operations while additional steps may be included with other operations.

Accordingly, device architectures and methods illustrated in the drawings and described herein reduce the cost of manufacture and reduction in power consumption of a demodulator. In an illustrative, non-limiting embodiment, a fully differential CMOS demodulator includes a CMOS bias control circuit, a CMOS squarer rectifier, a CMOS summing circuit, and a CMOS mismatch control circuit. The CMOS bias control circuit has a plurality of CMOS transistors and at least one resistor. The CMOS bias control circuit receives a reference voltage $V_G$ and produces a bias signal based upon the reference voltage $V_G$. The CMOS squarer rectifier has a plurality of CMOS transistors and a plurality of resistors. The CMOS squarer rectifier is biased by the bias signal, receives the reference voltage $V_G$ and input signals including a first modulated analog information signal $V_G+v_i$ and a second modulated analog information signal $V_G-v_i$, wherein $v_i$ is a single ended modulated analog information signal. The CMOS squarer rectifier demodulates the first and second modulated analog information signals to produce a set of demodulated information signals, which may include positive demodulated information signal $v_{dp}$, a negative demodulated information signal $v_{dn}$, an average voltage level $v_{cp}$ of the positive demodulated information signal $v_{dp}$, and an average voltage level $v_{cn}$ of the negative demodulated information signal $v_{dn}$. The CMOS summing circuit has a plurality of CMOS transistors and a plurality of resistors, is biased by the bias signal, receiving the set of demodulated information signals, which may include $v_{dp}$, $v_{dn}$, $v_{cp}$, and $v_{cn}$ in some embodiments and sums $v_{dp}$, $v_{dn}$, $v_{cp}$, and $v_{cn}$ to produce a differential demodulated information signal pair $v_{sp}$ and $v_{sn}$. The at least one CMOS gain stage is biased by the bias signal, receives the differential demodulated information signal pair $v_{sp}$ and $v_{sn}$, and amplifies the differential demodulated information signal pair $v_{sp}$ and $v_{sn}$ to produce an amplified differential information signal pair $v_{ap}$ and $v_{an}$. The CMOS mismatch control circuit has a plurality of CMOS transistors and a plurality of resistors, is biased by the bias signal, receives the amplified differential information signal pair $v_{ap}$ and $v_{an}$, and alters the differential demodulated information signal pair $v_{sp}$ and $v_{sn}$ for offset compensation.

The embodiment includes optional aspects. With one optional aspect, the fully differential CMOS demodulator includes an LNA transformer having a first coil receiving a filtered singled ended analog information signal from LNA and a second coil magnetically coupled to the first coil, the second coil having a center tap producing the voltage reference $V_G$, a positive terminal producing $V_G+v_i$ and negative terminal producing $V_G-v_i$. With another optional aspect the single ended modulated analog information signal is one of an On Off Keying (OOK) modulated signal and/or an Amplitude Shift Keying (ASK) modulated signal. With still another optional aspect, the CMOS squarer rectifier and the CMOS summing circuit are fully differential.

With yet another optional aspect, the CMOS squarer rectifier includes a current source controlled by the bias signal and having a current source input and a current source output coupled to ground. The CMOS squarer rectifier further includes a first leg having a first circuit including a first biasing resistor coupled in parallel with a first high pass filter, the first circuit coupled between a source voltage and a first output node producing $v_{dn}$, the first high pass filter producing $v_{cn}$ and a first CMOS transistor pair having a first transistor having a drain coupled to the first output node, a source coupled to the current source input, and a gate receiving $V_G + v_i$, and a second transistor coupled in parallel with the first transistor and having a drain coupled to the first output node, a source coupled to the current source input, and a gate receiving $V_G - v_i$. The CMOS squarer rectifier also includes a second leg coupled in parallel with the first leg and has a second circuit including a second biasing resistor coupled in parallel with a second high pass filter, the second circuit coupled between the source voltage and a second output node producing $v_{dp}$, the second high pass filter producing $v_{cp}$ and a second CMOS transistor pair that has a third transistor having a drain coupled to the second output node, a source coupled to the current source input, and a gate receiving $V_G$, and a fourth transistor coupled in parallel with the third transistor and having a drain coupled to the second output node, a source coupled to the current source input, and a gate receiving $V_G$.

With still another optional aspect the CMOS summing circuit includes a first differential amplifier and a second differential amplifier cross coupled with the first differential amplifier. With this optional aspect, the CMOS demodulator the first differential amplifier receives $v_{dn}$ and $v_{cn}$ and produces $v_{sn}$ and $v_{sp}$ and the second differential amplifier receives $v_{dp}$ and $v_{cp}$ and produces $v_{sn}$ and $v_{sp}$ in conjunction with the first differential amplifier via output coupling with the first differential amplifier.

With yet another optional aspect, each CMOS gain stage of the at least one CMOS gain stage comprises a source-coupled differential transistor pair with resistive loads. With still another optional aspect, the CMOS bias control circuit includes a two-stage operational transconductance amplifier with and a control resistor. Further, with another optional aspect the CMOS mismatch control circuit includes a differential amplifier and a differential low pass filter, the CMOS mismatch control circuit intercoupled with the CMOS summing circuit and the at least one CMOS gain stage.

With another illustrative, non-limiting embodiment, a fully differential CMOS demodulator includes a differential CMOS squarer rectifier having a plurality of CMOS transistors and a plurality of resistors, a differential CMOS summing circuit having a plurality of CMOS transistors and a plurality of resistors, and at least one differential CMOS gain stage having a plurality of CMOS transistors and a plurality of resistors. The CMOS squarer rectifier receives a reference voltage $V_G$ and input signals including a first modulated analog information signal $V_G+v_i$, and a second modulated analog information signal $V_G-v_i$, wherein $v_i$ is a single ended modulated analog information signal. The CMOS squarer rectifier circuit demodulates the first and second modulated analog information signals to produce a set of demodulated information signals, which include positive demodulated information signal $v_{dp}$, a negative demodulated information signal $v_{dn}$, an average voltage level $v_{cp}$ of the positive demodulated information signal $v_{dp}$, and an average voltage level $v_{cn}$ of the negative demodulated information signal $v_{dn}$ in some embodiments. The differential CMOS summing circuit receives the set of demodulated information signals $v_{dp}$, $v_{dn}$, $v_{cp}$, and $v_{cn}$ and sums $v_{dp}$, $v_{dn}$, $v_{cp}$, and $v_{cn}$ to produce a differential demodulated information signal pair $v_{sp}$ and $v_{sn}$. The at least one differential CMOS gain stage receives the differential demodulated information signal pair $v_{sp}$ and $v_{sn}$ and amplifies the differential demodulated information signal pair $v_{sp}$ and $v_{sn}$ to produce an amplified differential information signal pair $v_{ap}$ and $v_{an}$.

The embodiment includes optional aspects. With one optional aspect, the single ended modulated analog information signal is one of an On Off Keying (OOK) modulated signal and/or an Amplitude Shift Keying (ASK) modulated signal. With another optional aspect, the CMOS squarer rectifier and the CMOS summing circuit are fully differential.

With yet another optional aspect, the CMOS squarer rectifier includes a current source controlled by the bias signal and having a current source input and a current source output coupled to ground. The CMOS squarer rectifier further includes a first leg having a first circuit including a first biasing resistor coupled in parallel with a first high pass filter, the first circuit coupled between a source voltage and a first output node producing $v_{dn}$, the first high pass filter producing $v_{cn}$ and a first CMOS transistor pair having a first transistor having a drain coupled to the first output node, a source coupled to the current source input, and a gate receiving $V_G + v_i$, and a second transistor coupled in parallel with the first transistor and having a drain coupled to the first output node, a source coupled to the current source input, and a gate receiving $V_G - v_i$. The CMOS squarer rectifier also includes a second leg coupled in parallel with the first leg and has a second circuit including a second biasing resistor coupled in parallel with a second high pass filter, the second circuit coupled between the source voltage and a second output node producing $v_{dp}$, the second high pass filter producing $v_{cp}$ and a second CMOS transistor pair that has a third transistor having a drain coupled to the second output node, a source coupled to the current source input, and a gate receiving $V_G$, and a fourth transistor coupled in parallel with the third transistor and having a drain coupled to the second output node, a source coupled to the current source input, and a gate receiving $V_G$.

With still another optional aspect the CMOS summing circuit includes a first differential amplifier and a second differential amplifier cross coupled with the first differential amplifier. With this optional aspect, the CMOS demodulator includes the first differential amplifier receives $v_{dn}$ and $v_{cn}$ and produces $v_{sn}$ and $v_{sp}$ and the second differential amplifier receives $v_{dp}$ and $v_{cp}$ and produces $v_{sn}$ and $v_{sp}$ in conjunction with the first differential amplifier via output coupling with the first differential amplifier.

With yet another optional aspect, each CMOS gain stage of the at least one CMOS gain stage comprises a source-coupled differential transistor pair with resistive loads. With still another optional aspect, the CMOS bias control circuit includes a two-stage operational transconductance amplifier with and a control resistor. Further, with another optional aspect the CMOS mismatch control circuit includes a differential amplifier and a differential low pass filter, the CMOS mismatch control circuit intercoupled with the CMOS summing circuit and the at least one CMOS gain stage.

With yet another illustrative, non-limiting embodiment a method for operating a fully differential CMOS demodulator comprising includes operations of components of the fully differential CMOS demodulator. A CMOS bias control circuit receives a reference voltage $V_G$ and producing a bias signal based upon the reference voltage $V_G$. A CMOS squarer rectifier is biased by the bias signal receives the reference voltage $V_G$ and input signals including a first modulated analog information signal $V_G+v_i$, and a second modulated analog information signal $V_G-v_i$, wherein $v_i$ is a single ended modulated analog information signal. The CMOS squarer rectifier demodulates the first and second modulated analog information signals to produce a set of demodulated information signals, which may include a positive demodulated information signal $v_{dp}$, a negative demodulated information signal $v_{dn}$, an average voltage level $v_{cp}$ of the positive demodulated information signal $v_{dp}$, and an average voltage level $v_{cn}$ of the negative demodulated information signal $v_{dn}$. A CMOS summing is circuit biased by the bias signal, receives the set of demodulated information signals ($v_{dp}$, $v_{dn}$, $v_{cp}$, and $v_{cn}$) and sums the set of demodulated information signals to produce a differential demodulated information signal pair $v_{sp}$ and $v_{sn}$. At least one CMOS gain stage is biased by the bias signal, receives the differential demodulated information signal pair $v_{sp}$ and $v_{sn}$, and amplifies the differential demodulated information signal pair $v_{sp}$ and $v_{sn}$ to produce an amplified differential information signal pair $v_{ap}$ and $v_{an}$. A CMOS mismatch control circuit is biased by the bias signal, receives the amplified differential information signal pair $v_{ap}$ and $v_{an}$ and alters the differential demodulated information signal pair $v_{sp}$ and $v_{sn}$ for offset compensation.

The method of this embodiment includes optional aspects. With a first optional aspect the method includes, by a LNA transformer, receiving a filtered singled ended analog information signal from LNA via a first coil. A second coil, which is magnetically coupled to the first coil produces the voltage reference $V_G$ at a center tap of the second coil, produces $V_G+v_i$ at a first terminal of the second coil, and produces $V_G-v_i$ at a second terminal of the second coil. With another optional aspect, the single ended modulated analog information signal is one of an On Off Keying (OOK) modulated signal and/or an Amplitude Shift Keying (ASK) modulated signal.

With another optional aspect of this embodiment, a first leg of the CMOS squarer rectifier receives $V_G + v$; and $V_G - v$; and produces $v_{dn}$ and $v_{cn}$. Further, a second leg of the CMOS squarer rectifier receives $V_G$ and produces $v_{dp}$ and $v_{cp}$. With still another optional aspect, receiving $v_{dn}$ and $v_{cn}$ and producing $v_{sn}$ and $v_{sp}$ is done by a first differential amplifier of the CMOS summing circuit. Further, receiving $v_{dp}$ and $v_{cp}$ and producing $v_{sn}$ and $v_{sp}$ is done by a second differential amplifier in conjunction with the first differential amplifier via output coupling.

As may be used herein, the term(s) "configured to", "operably coupled to", "coupled to", and/or "coupling" includes direct coupling between items and/or indirect coupling between items via an intervening item (e.g., an item includes, but is not limited to, a component, an element, a circuit, and/or a module) where, for an example of indirect coupling, the intervening item does not modify the information of a signal but may adjust its current level, voltage level, and/or power level. As may further be used herein, inferred coupling (i.e., where one element is coupled to another element by inference) includes direct and indirect coupling between two items in the same manner as "coupled to".

As may even further be used herein, the term "configured to", "operable to", "coupled to", or "operably coupled to" indicates that an item includes one or more of power connections, ground connections, input(s), output(s), etc., to perform, when activated, one or more of its corresponding functions and may further include inferred coupling to one or more other items. As may still further be used herein, the term "associated with", includes direct and/or indirect coupling of separate items and/or one item being embedded within another item.

As may be used herein, one or more claims may include, in a specific form of this generic form, the phrase "at least one of a, b, and c" or of this generic form "at least one of a, b, or c", with greater or fewer elements than "a", "b", and "c". In either phrasing, the phrases are to be interpreted identically. In particular, "at least one of a, b, and c" is equivalent to "at least one of a, b, or c" and shall mean a, b, and/or c. As an example, it means: "a" only, "b" only, "c" only, "a" and "b", "a" and "c", "b" and "c", and/or "a", "b", and "c".

As may also be used herein, the terms "processing module", "processing circuit", "processor", "digital signal processor", "processing circuitry", and/or "processing unit" may be a single processing device or a plurality of processing devices. Such a processing device may be a microprocessor, micro-controller, digital signal processor, microcomputer, central processing unit, field programmable gate array, programmable logic device, state machine, logic circuitry, analog circuitry, digital circuitry, and/or any device that manipulates signals (analog and/or digital) based on hard coding of the circuitry and/or operational instructions. The processing module, module, processing circuit, processing circuitry, and/or

processing unit may be, or further include memory and/or an integrated memory element, which may be a single memory device, a plurality of memory devices, and/or embedded circuitry of another processing module, module, processing circuit, processing circuitry, and/or processing unit. Such a memory device may be a read-only memory, random access memory, volatile memory, non-volatile memory, static memory, dynamic memory, flash memory, cache memory, and/or any device that stores digital information. Note that if the processing module, module, processing circuit, processing circuitry, and/or processing unit includes more than one processing device, the processing devices may be centrally located (e.g., directly coupled together via a wired and/or wireless bus structure) or may be distributed located (e.g., cloud computing via indirect coupling via a local area network and/or a wide area network). Further note that if the processing module, module, processing circuit, processing circuitry and/or processing unit implements one or more of its functions via a state machine, analog circuitry, digital circuitry, and/or logic circuitry, the memory and/or memory element storing the corresponding operational instructions may be embedded within, or external to, the circuitry comprising the state machine, analog circuitry, digital circuitry, and/or logic circuitry. Still further note that, the memory element may store, and the processing module, module, processing circuit, processing circuitry and/or processing unit executes, hard coded and/or operational instructions corresponding to at least some of the steps and/or functions illustrated in one or more of the FIGs. Such a memory device or memory element can be included in an article of manufacture.

One or more embodiments have been described above with the aid of method steps illustrating the performance of specified functions and relationships thereof. The boundaries and sequence of these functional building blocks and method steps have been arbitrarily defined herein for convenience of description. Alternate boundaries and sequences can be defined so long as the specified functions and relationships are appropriately performed. Any such alternate boundaries or sequences are thus within the scope and spirit of the claims.

To the extent used, the flow diagram block boundaries and sequence could have been defined otherwise and still perform the certain significant functionality. Such alternate definitions of both functional building blocks and flow diagram blocks and sequences are thus within the scope and spirit of the claims. One of average skill in the art will also recognize that the functional building blocks, and other illustrative blocks, modules and components herein, can be implemented as illustrated or by discrete components, application specific integrated circuits, processors executing appropriate software and the like or any combination thereof.

In addition, a flow diagram may include a "start" and/or "continue" indication. The "start" and "continue" indications reflect that the steps presented can optionally be incorporated in or otherwise used in conjunction with one or more other routines. In addition, a flow diagram may include an "end" and/or "continue" indication. The "end" and/or "continue" indications reflect that the steps presented can end as described and shown or optionally be incorporated in or otherwise used in conjunction with one or more other routines. In this context, "start" indicates the beginning of the first step presented and may be preceded by other activities not specifically shown. Further, the "continue" indication reflects that the steps presented may be performed multiple times and/or may be succeeded by other activities not specifically shown. Further, while a flow diagram indicates a particular ordering of steps, other orderings are likewise possible provided that the principles of causality are maintained.

The one or more embodiments are used herein to illustrate one or more aspects, one or more features, one or more concepts, and/or one or more examples. A physical embodiment of an apparatus, an article of manufacture, a machine, and/or of a process may include one or more of the aspects, features, concepts, examples, etc. described with reference to one or more of the embodiments discussed herein. Further, from FIG. to FIG., the embodiments may incorporate the same or similarly named functions, steps, modules, etc. that may use the same or different reference numbers and, as such, the functions, steps, modules, etc. may be the same or similar functions, steps, modules, etc. or different ones.

While CMOS transistors may be shown in one or more of the above-described figure(s) as field effect transistors (FETs), as one of ordinary skill in the art will appreciate, the transistors may be implemented using any type of transistor structure including, but not limited to, metal oxide semiconductor field effect transistors (MOSFET), N-well transistors, P-well transistors, enhancement mode, depletion mode, and zero voltage threshold (VT) transistors constructed in a CMOS process.

Unless specifically stated to the contra, signals to, from, and/or between elements in a figure of any of the figures presented herein may be analog or digital, continuous time or discrete time, and single-ended or differential. For instance, if a signal path is shown as a single-ended path, it also represents a differential signal path. Similarly, if a signal path is shown as a differential path, it also represents a single-ended signal path. While one or more architectures are described herein, other architectures can likewise be implemented that use one or more data buses not expressly shown, direct connectivity between elements, and/or indirect coupling between other elements as recognized by one of average skill in the art.

While combinations of various functions and features of the one or more embodiments have been expressly described herein, other combinations of these features and functions are likewise possible. The present disclosure is not limited by the examples disclosed herein and expressly incorporates these other combinations.

**Claims**

1. A fully differential CMOS demodulator comprising:

   a CMOS bias control circuit receiving a reference voltage $V_G$ and producing a bias signal based upon the reference voltage $V_G$;
   a CMOS squarer rectifier:

   biased by the bias signal,
   receiving the reference voltage $V_G$ and input signals including a first modulated analog information signal $V_G+v_i$, and a second modulated analog information signal $V_G-v_i$, wherein $v_i$ is a single ended modulated analog information signal:
   demodulating the first and second modulated analog information signals to produce a set of demodulated information signals;

   a CMOS summing circuit:

   biased by the bias signal;
   receiving the set of demodulated information signals; and
   summing the set of demodulated information signals to produce a differential demodulated information signal pair $v_{sp}$ and $v_{sn}$;

   at least one CMOS gain stage:
   biased by the bias signal; and
   receiving the differential demodulated information signal pair $v_{sp}$ and $v_{sn}$; and
   amplifying the differential demodulated information signal pair $v_{sp}$ and $v_{sn}$ to produce an amplified differential information signal pair $v_{ap}$ and $v_{an}$; and
   a CMOS mismatch control circuit:

   biased by the bias signal;
   receiving the amplified differential information signal pair $v_{ap}$ and $v_{an}$; and
   altering the differential demodulated information signal pair $v_{sp}$ and $v_{sn}$ for offset compensation.

2. The fully differential CMOS demodulator of claim 1, wherein the single ended modulated analog information signal is one of:

   an On Off Keying (OOK) modulated signal; and
   an Amplitude Shift Keying (ASK) modulated signal.

3. The fully differential CMOS demodulator of claim 1 or 2, wherein the CMOS squarer rectifier and the CMOS summing circuit are fully differential.

4. The fully differential CMOS demodulator of any preceding claim, wherein each CMOS gain stage of the at least one CMOS gain stage comprises a source-coupled differential transistor pair with resistive loads.

5. The fully differential CMOS demodulator of any preceding claim, wherein the CMOS bias control circuit comprises a two-stage operational transconductance amplifier with and a control resistor.

6. The fully differential CMOS demodulator of any preceding claim, wherein the CMOS mismatch control circuit comprises a differential amplifier and a differential low pass filter intercoupled with the CMOS summing circuit and the at least one CMOS gain stage.

7. The fully differential CMOS demodulator of any preceding claim, wherein the set of demodulated information signals comprises a positive demodulated information signal $v_{dp}$, a negative demodulated information signal $v_{dn}$, an average voltage level $v_{cp}$ of the positive demodulated information signal $v_{dp}$, and an average voltage level $v_{cn}$ of the negative demodulated information signal $v_{dn}$.

8. The fully differential CMOS demodulator of claim 7, wherein the CMOS squarer rectifier comprises:

a current source controlled by the bias signal and having a current source input and a current source output coupled to ground;
a first leg having:

a first circuit including a first biasing resistor coupled in parallel with a first high pass filter, the first circuit coupled between a source voltage and a first output node producing $v_{dn}$, the first high pass filter producing $v_{cn}$;
a first CMOS transistor pair having:

a first transistor having a drain coupled to the first output node, a source coupled to the current source input, and a gate receiving $V_G + v_i$; and
a second transistor coupled in parallel with the first transistor and having a drain coupled to the first output node, a source coupled to the current source input, and a gate receiving $V_G - v_i$; and

a second leg coupled in parallel with the first leg and having:

a second circuit including a second biasing resistor coupled in parallel with a second high pass filter, the second circuit coupled between the source voltage and a second output node producing $v_{dp}$, the second high pass filter producing $v_{cp}$;
a second CMOS transistor pair having:

a third transistor having a drain coupled to the second output node, a source coupled to the current source input, and a gate receiving $V_G$; and
a fourth transistor coupled in parallel with the third transistor and having a drain coupled to the second output node, a source coupled to the current source input, and a gate receiving $V_G$.

9. The fully differential CMOS demodulator of claim 7 or 8, wherein the CMOS summing circuit comprises:

a first differential amplifier; and
a second differential amplifier cross coupled with the first differential amplifier.

10. The fully differential CMOS demodulator of any of claims 7 to 9, wherein:

the first differential amplifier receives $v_{dn}$ and $v_{cn}$ and produces $v_{sn}$ and $v_{sp}$; and
the second differential amplifier receives $v_{dp}$ and $v_{cp}$ and produces $v_{sn}$ and $v_{sp}$ in conjunction with the first differential amplifier via output coupling with the first differential amplifier.

11. A method for operating a fully differential CMOS demodulator comprising:

by a CMOS bias control circuit, receiving a reference voltage $V_G$ and producing a bias signal based upon the reference voltage $V_G$;
by a CMOS squarer rectifier biased by the bias signal:
receiving the reference voltage $V_G$ and input signals including a first modulated analog information signal $V_G+v_i$, and a second modulated analog information signal $V_G-v_i$, wherein $v_i$ is a single ended modulated analog information signal:
demodulating the first and second modulated analog information signals to produce to produce a set of demodulated information signals;
by a CMOS summing circuit biased by the bias signal:

receiving the set of demodulated information signals; and
summing the set of demodulated information signals to produce a differential demodulated information signal pair $v_{sp}$ and $v_{sn}$;

by at least one CMOS gain stage biased by the bias signal:

receiving the differential demodulated information signal pair $v_{sp}$ and $v_{sn}$; and
amplifying the differential demodulated information signal pair $v_{sp}$ and $v_{sn}$ to produce an amplified differential information signal pair $v_{ap}$ and $v_{an}$; and

by a CMOS mismatch control circuit biased by the bias signal:

receiving the amplified differential information signal pair $v_{ap}$ and $v_{an}$; and
altering the differential demodulated information signal pair $v_{sp}$ and $v_{sn}$ for offset compensation.

12. The method of claim 11 further comprising by a Low Noise Amplifier (LNA) transformer:

receiving a filtered singled ended analog information signal from LNA via a first coil; and
by a second coil magnetically coupled to the first coil:

producing the voltage reference $V_G$ at a center tap of the second coil
producing $V_G+_{Vi}$ at a first terminal of the second coil; and
producing $V_G-v_i$ at a second terminal of the second coil.

13. The method of claim 11 or 12, wherein the single ended modulated analog information signal is one of:

an On Off Keying (OOK) modulated signal; and
an Amplitude Shift Keying (ASK) modulated signal.

14. The method of any of claims 11 to 13, wherein:

the set of demodulated information signals includes a positive demodulated information signal $v_{dp}$, a negative demodulated information signal $v_{dn}$, an average voltage level $v_{cp}$ of the positive demodulated information signal $v_{dp}$, and an average voltage level $v_{cn}$ of the negative demodulated information signal $v_{dn}$;
a first leg of the CMOS squarer rectifier:

receives $V_G + v$; and $V_G - v_i$; and
produces $v_{dn}$ and $v_{cn}$; and

a second leg of the CMOS squarer rectifier:

receives $V_G$; and
produces $v_{dp}$ and $v_{cp}$.

15. The method of claim 14, wherein:

receiving $v_{dn}$ and $v_{cn}$ and producing $v_{sn}$ and $v_{sp}$ is done by a first differential amplifier of the CMOS summing circuit; and
receiving $v_{dp}$ and $v_{cp}$ and producing $v_{sn}$ and $v_{sp}$ is done by a second differential amplifier in conjunction with the first differential amplifier via output coupling.

EP 4 730 648 A1

FIG. 1

100

FIG. 2

FIG. 3

FIG. 4

EP 4 730 648 A1

$$V_G + v_i \qquad\qquad V_G - v_i$$

$$V_I$$

OFF ON OFF     OFF ON OFF    dc level

500

## FIG. 5A

**Outputs**

$$v_{dp}$$

$$V_{OM} \qquad v_{cp}$$

$$v_{dn} \qquad\qquad\qquad\qquad \text{dc level}$$

$$v_{cn}$$

OFF ON OFF     OFF ON OFF

550

## FIG. 5B

FIG. 6

EP 4 730 648 A1

**Inputs**

$V_{dn}$

OFF ON OFF

$V_{cn}$

same
voltage level

$V_{dp}$

$V_{cp}$

OFF ON OFF

702

$V_{dn}$ ○—— + −

$V_{cn}$ ○—— − +

704

$V_{cp}$ ○—— + −

$V_{dp}$ ○—— − +

——○ $V_{sn}$

——○ $V_{sp}$

**Outputs**

OFF ON OFF

Same dc
level

206

**FIG. 7**

EP 4 730 648 A1

FIG. 8

**FIG. 9A**

**FIG. 9B**

FIG. 10

**FIG. 11**

EP 4 730 648 A1

FIG. 12

START

1302

A CMOS BIAS CONTROL CIRCUIT RECEIVING A REFERENCE VOLTAGE $V_G$ AND PRODUCING A BIAS SIGNAL BASED UPON THE REFERENCE VOLTAGE $V_G$

1304

A CMOS SQUARER RECTIFIER RECEIVING THE REFERENCE VOLTAGE $V_G$ AND INPUT SIGNALS INCLUDING A FIRST MODULATED ANALOG INFORMATION SIGNAL $V_G+V_I$, AND A SECOND MODULATED ANALOG INFORMATION SIGNAL $V_G-V_I$, WHEREIN $V_I$ IS A SINGLE ENDED MODULATED ANALOG INFORMATION SIGNAL

1306

THE CMOS SQUARER RECTIFIER DEMODULATING THE FIRST AND SECOND MODULATED ANALOG INFORMATION SIGNALS TO PRODUCE A POSITIVE DEMODULATED INFORMATION SIGNAL $V_{DP}$, A NEGATIVE DEMODULATED INFORMATION SIGNAL $V_{DN}$, AN AVERAGE VOLTAGE LEVEL $V_{CP}$ OF THE POSITIVE DEMODULATED INFORMATION SIGNAL $V_{DP}$, AND AN AVERAGE VOLTAGE LEVEL $V_{CN}$ OF THE NEGATIVE DEMODULATED INFORMATION SIGNAL $V_{DN}$

1308

A CMOS SUMMING CIRCUIT SUMMING $V_{DP}$, $V_{DN}$, $V_{CP}$, AND $V_{CN}$ TO PRODUCE A DIFFERENTIAL DEMODULATED INFORMATION SIGNAL PAIR $V_{SP}$ AND $V_{SN}$;

1310

AT LEAST ONE CMOS GAIN STAGE AMPLIFYING THE DIFFERENTIAL DEMODULATED INFORMATION SIGNAL PAIR $V_{SP}$ AND $V_{SN}$ TO PRODUCE AN AMPLIFIED DIFFERENTIAL INFORMATION SIGNAL PAIR $V_{AP}$ AND $V_{AN}$; AND

1312

A CMOS MISMATCH CONTROL CIRCUIT ALTERING THE DIFFERENTIAL DEMODULATED INFORMATION SIGNAL PAIR $V_{SP}$ AND $V_{SN}$ FOR OFFSET COMPENSATION.

END

1300

FIG. 13

Europäisches
Patentamt
European
Patent Office
Office européen
des brevets

# EUROPEAN SEARCH REPORT

**Application Number**

EP 24 20 7585

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | YODPRASIT UROSCHANIT ET AL: "11.5-Gbps 2.4-pJ/bit 60-GHz OOK demodulator integrated in a SiGe BiCMOS technology", 2013 EUROPEAN MICROWAVE INTEGRATED CIRCUIT CONFERENCE, EUROPEAN MICROWAVE ASSOCIATION, 6 October 2013 (2013-10-06), pages 1-4, XP032533911, [retrieved on 2013-12-18] * figures 1-4 * | 1-15 | INV. H03D1/18 |
| A | KAI KANG ET AL: "A 60-GHz OOK Receiver With an On-Chip Antenna in 90 nm CMOS", IEEE JOURNAL OF SOLID-STATE CIRCUITS, IEEE, USA, vol. 45, no. 9, 30 September 2010 (2010-09-30), pages 1720-1731, XP011317131, ISSN: 0018-9200, DOI: 10.1109/JSSC.2010.2053095 * figures 5, 6 * | 1-15 | |

-----

-----

**TECHNICAL FIELDS SEARCHED (IPC)**

H03D

The present search report has been drawn up for all claims

| Place of search | Date of completion of the search | Examiner |
|---|---|---|
| Munich | 25 March 2025 | Schnabel, Florian |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P4C01)